# FASCICULE DE BREVET EUROPEEN

(11) **EP 3 090 487 B1**
(45) Date de publication et mention de la délivrance du brevet: **31.01.2018**
(21) Numéro de dépôt: 14815311.7
(22) Date de dépôt: 15.12.2014
(51) Int. Cl.: H03K 5/15

(54) **CIRCUIT DE GÉNÉRATION D'AU MOINS DEUX SIGNAUX RECTANGULAIRES À DÉPHASAGE RÉGLABLE ET UTILISATION DUDIT CIRCUIT**
SCHALTUNG ZUR ERZEUGUNG VON MINDESTENS ZWEI RECHTECKFÖRMIGEN SIGNALEN MIT EINSTELLBARER PHASENVERSCHIEBUNG UND VERWENDUNG DIESER SCHALTUNG
CIRCUIT FOR GENERATING AT LEAST TWO RECTANGULAR SIGNALS WITH ADJUSTABLE PHASE SHIFT AND USE OF SAID CIRCUIT

(30) Priorité: 31.12.2013 FR 1303120
(43) Date de publication de la demande: 09.11.2016
(73) Titulaire: THALES, 92400 Courbevoie (FR)
(72) Inventeur: GUEPRATTE, Kevin, F-29200 Brest (FR); LE BARS, David, F-29200 Brest (FR); STEPHAN, Hervé, F-29200 Brest (FR)
(74) Mandataire: Brunelli, Gérald
(86) Numéro de dépôt international: PCT/EP2014/077723
(87) Numéro de publication internationale: WO 2015/101475

(56) Documents cités:
- US-A- 5 367 204
- US-A- 5 652 533
- US-A1- 2010 123 497

## Description

La présente invention concerne la génération de signaux. La présente invention concerne plus particulièrement un circuit de génération d'au moins deux signaux rectangulaires à déphasage réglable. Ce circuit peut notamment être utilisé dans un convertisseur d'énergie de type ^{«} phase shift ^{»}.

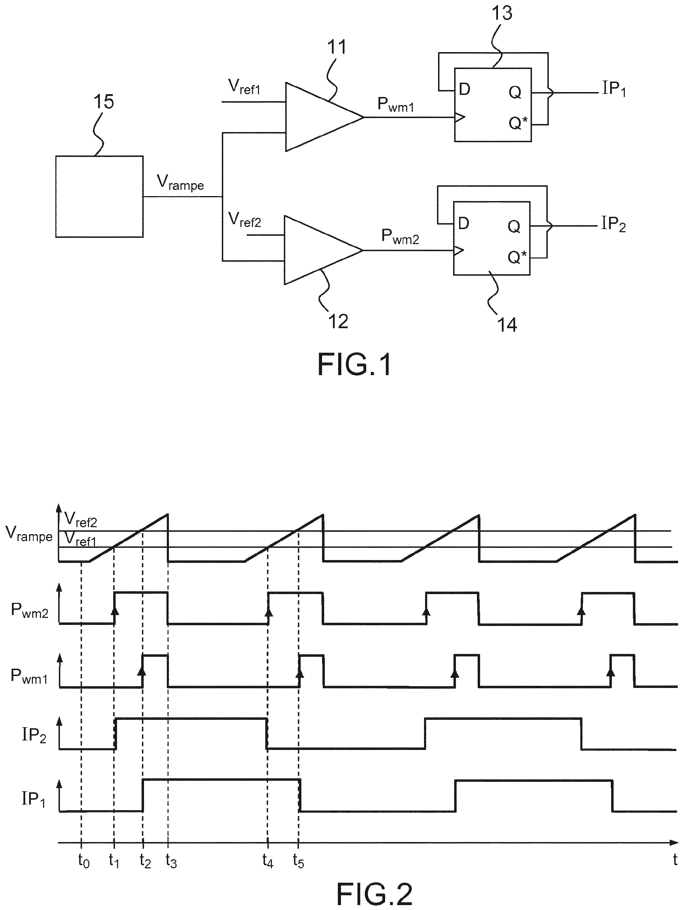

La figure 1 représente un circuit de génération de signaux rectangulaires à déphasage réglable connu de l'art antérieur. Le circuit comprend deux comparateurs 11, 12 et deux bascules 13, 14 de type ^{«} D ^{»}. Chaque comparateur 11, 12 reçoit sur une de ses entrées de comparaison un signal triangulaire de rampe, fourni par un dispositif de génération de signaux 15, et sur l'autre entrée une tension de référence Vref₁, Vref₂. La sortie de chaque comparateur 11, 12 est connectée à une bascule 13, 14 montée en diviseur de fréquence par deux, active au front montant.

Le fonctionnement du circuit va être expliqué en référence à la figure 2. Le premier chronogramme représente l'allure du signal de rampe. On suppose qu'au temps t₀ tous les signaux sont à l'état bas.

Au temps t₁, la valeur du signal de rampe Vᵣₐₘₚₑ devient supérieure à la valeur de la première tension de référence Vref₁, le signal de sortie P_{wm1} du premier comparateur 11 passe de l'état bas à l'état haut. Ce front montant va faire déclencher la première bascule ^{«} D ^{»} 13 et son signal de sortie IP₁ va passer à l'état haut.

Le même phénomène va se reproduire avec le deuxième comparateur 12 et la deuxième bascule 14 au temps t₂ lorsque la valeur du signal de rampe Vᵣₐₘₚₑ va devenir supérieure à la valeur de la deuxième tension de référence Vref₂.

Au temps t₃, la valeur du signal de rampe revient à zéro, la sortie P_{wm1}, P_{wm2} des deux comparateurs 13, 14 passe de l'état haut à l'état bas. Les bascules 13, 14 étant actives au front montant, les signaux IP₁, IP₂ en sortie de ces dernières restent inchangés.

Au temps t₄, la valeur du signal de rampe Vᵣₐₘₚₑ devient de nouveau supérieure à la valeur de la première tension de référence Vref₁. La sortie du premier comparateur 11 passe de l'état bas à l'état haut. Ce front montant va faire déclencher la première bascule ^{«} D ^{»} 13 et son signal de sortie IP₁ va passer de l'état haut à l'état bas.

De même, le signal de sortie de la deuxième bascule 14 IP₂ passe de l'état haut à l'état bas au temps t₅.

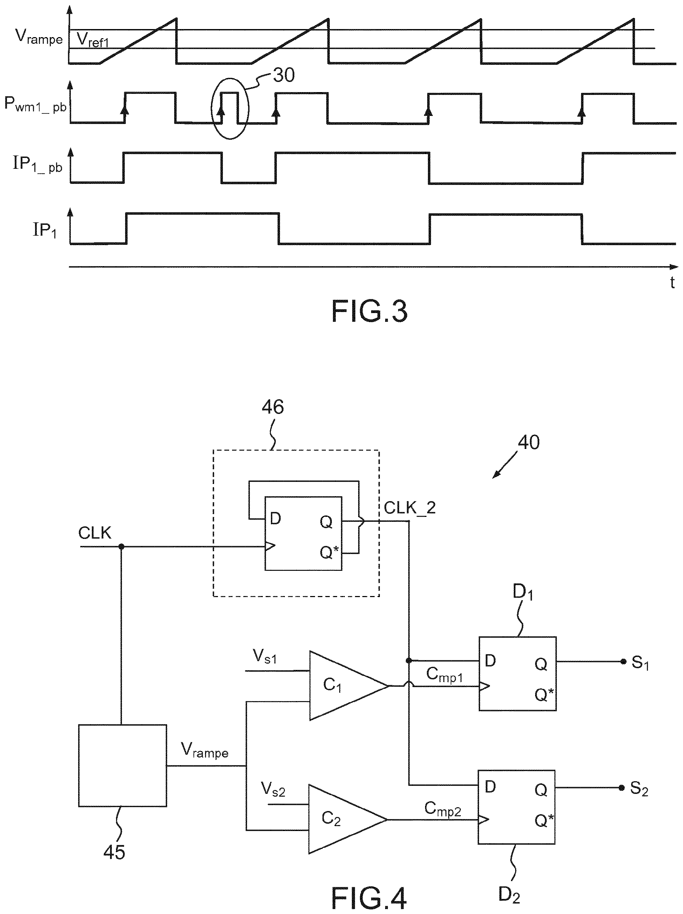

Un problème se pose lorsqu'un parasite apparaît sur le signal de sortie d'un comparateur. Ce cas de figure est illustré figure 3 à travers un exemple dans lequel une impulsion parasite 30 apparaît sur le signal de sortie P_{wm1_Pb} du premier comparateur.

Sur cette figure, le premier chronogramme représente le signal de rampe. Le deuxième et le troisième chronogramme représentent respectivement l'allure du signal en sortie du premier comparateur P_{wm1_Pb} et l'allure du signal en sortie IP₁_Pb de la première bascule D. Le dernier chronogramme sert de comparaison et représente la forme du signal en sortie de la bascule dans le cas où le signal en sortie de comparateur n'est pas parasité.

On remarque que le front montant du parasite fait déclencher la bascule en sortie du comparateur et perturbe le signal de sortie de manière permanente.

Un problème se pose également au démarrage du circuit, au moment de sa mise sous tension car on ne sait pas si les bascules sont à l'état haut ou à l'état bas.

Il est possible de forcer les bascules à l'état bas au démarrage grâce à l'entrée de remise à zéro (ou *reset* selon la terminologie anglo-saxonne) desdites bascules. Cependant ces systèmes de remise à zéro sont aléatoires et les temps de montée des fonctions de remise à zéro ne sont pas fiables. Du fait de l'incertitude de la remise à zéro, le signal de rampe peut par exemple démarrer avant que les bascules soient initialisées. Ainsi, lorsque les bascules seront prêtes à démarrer, on se trouvera entre les deux fronts montants et donc un seul des deux fronts montants aura été pris en compte au démarrage. Les deux basculements seront alors décalés de 180°.

Un autre problème peut se poser si les deux commandes de remise à zéro ne se font pas exactement au même instant.

Il est connu dans l'art antérieur, notamment par le brevet américain US 5 652 533 un circuit destiné à générer des signaux d'échantillonnage à des intervalles de temps rapprochés.

La demande de brevet US 2010/123 497 enseigne une ligne à retard de phase.

Il est également connu dans l'art antérieur, par exemple, par le brevet US 5 367 204 un circuit de génération d'horloge de bord multiples à partir d'une entrée d'horloge unique.

Un but de l'invention est notamment de corriger un ou plusieurs des inconvénients de l'art antérieur en proposant une solution permettant de s'affranchir des problèmes d'initialisation des bascules et des parasites.

A cet effet, l'invention a pour objet un circuit de génération d'au moins deux signaux rectangulaires à déphasage réglable comprenant :
- un circuit diviseur de fréquence recevant en entrée un premier signal d'horloge et fournissant en sortie un deuxième signal d'horloge,
- au moins deux comparateurs, recevant respectivement sur une entrée de comparaison une première tension de seuil et au moins une seconde tension de seuil et sur une seconde entrée de comparaison un signal triangulaire de rampe synchronisé avec le signal d'horloge, le groupe d'au moins deux tensions de seuil permettant de régler la valeur du déphasage entre les signaux du groupe d'au moins deux signaux rectangulaires à déphasage réglable,
- au moins deux bascules de type D recevant respectivement sur leurs entrées d'horloge, le signal de sortie du premier comparateur et le signal de sortie du deuxième comparateur et sur leur entrée ^{«} D ^{»}, le signal de sortie du circuit diviseur de fréquence,
le groupe d'au moins deux signaux rectangulaires à déphasage réglable étant disponible sur les sorties ^{«} Q ^{»} du groupe d'au moins deux bascules de type D.

Selon un mode de réalisation, le circuit diviseur de fréquence et un diviseur de fréquence par deux.

Selon un mode de réalisation, le circuit diviseur de fréquence comprend une bascule de type ^{«} D ^{»} dont l'entrée D est connectée à la sortie complémentaire ^{«} Q* ^{»}.

Selon un mode de réalisation, le circuit comprend en outre un circuit d'horloge configuré pour générer un signal triangulaire de rampe, ledit circuit d'horloge recevant en entrée le signal d'horloge et la sortie dudit circuit d'horloge étant connecté à une des deux entrées de comparaison de chaque comparateur.

L'invention a également pour objet un convertisseur de puissance à décalage de phase comprenant un circuit de génération de deux signaux rectangulaires à déphasage réglable comme décrit précédemment, lesdits signaux rectangulaires étant configurés pour commander des commutateurs des ponts primaire et secondaire dudit convertisseur de puissance.

D'autres particularités et avantages de la présente invention apparaîtront plus clairement à la lecture de la description ci-après, donnée à titre illustratif et non limitatif, et faite en référence aux dessins annexés, dans lesquels :
- la figure 1, précédemment décrite, représente un circuit de génération d'au moins deux signaux rectangulaires à déphasage réglable connu de l'art antérieur ;
- la figure 2, précédemment décrite, représente l'allure des signaux à différents points du circuit de la figure 1 ;
- la figure 3, précédemment décrite, représente l'allure des signaux à différents points du circuit de la figure 1 dans un cas de figure particulier ;
- la figure 4 représente un exemple de mode de réalisation d'un circuit de génération d'au moins deux signaux rectangulaires à déphasage réglable selon l'invention ;
- la figure 5 représente des exemples d'allure des signaux à différents points du circuit de la figure 4 ;
- la figure 6 représente des exemples d'allure des signaux à différents points du circuit de la figure 4 lorsque des parasites apparaissent.
- La figure 7 représente un exemple de mode de réalisation d'un convertisseur d'énergie à décalage de phase dans lequel les signaux de commande des commutateurs des convertisseurs DC/AC et AC-DC sont déphasés à l'aide d'un circuit de génération d'au moins deux signaux rectangulaires à déphasage réglable selon un mode de réalisation de l'invention.

La figure 4 représente un exemple de mode de réalisation d'un circuit 40 de génération d'au moins deux signaux rectangulaires à déphasage réglable selon l'invention. Afin de simplifier les explications et de ne pas surcharger les figures, on a représenté un cas particulier où le nombre de signaux généré est égal à deux.

Dans ce mode de réalisation le circuit comprend un circuit diviseur de fréquence 46, deux comparateurs C1, C2 et deux bascules de type ^{«} D ^{»} D1, D2.

Suivant un mode de réalisation, le circuit diviseur de fréquence 46 peut être un circuit diviseur de fréquence par deux.

Suivant un mode de réalisation, le circuit diviseur 46 peut être réalisé à l'aide d'une bascule de type ^{«} D ^{»} dont l'entrée D est connectée à la sortie complémentaire ^{«} Q* ^{»}

Dans le mode de réalisation illustré figure 4, le circuit diviseur de fréquence 46 reçoit en entrée un premier signal d'horloge CLK et fournit en sortie un deuxième signal d'horloge CLK_2.

Le premier comparateur C1 reçoit sur une de ses entrées de comparaison un premier signal Vs₁ et sur la seconde entrée un signal triangulaire de rampe Vᵣₐₘₚₑ.

Le deuxième comparateur C2 reçoit sur une de ses entrées de comparaison un deuxième signal Vs₂ et sur la seconde entrée le même signal triangulaire Vᵣₐₘₚₑ que précédemment.

Les deux signaux Vs₁ et Vs₂ sont des tensions analogiques permettant de définir le déphasage entre les deux signaux rectangulaires à déphasage réglable.

Le signal triangulaire de rampe est synchronisé avec le premier signal d'horloge CLK du circuit diviseur de fréquence 46. Le signal premier d'horloge CLK peut servir à générer le signal de rampe.

Suivant un mode réalisation, le circuit 40 de génération d'au moins deux signaux rectangulaires S₁, S₂ à déphasage réglable peut comprendre un circuit d'horloge 45 configuré pour générer un signal triangulaire de rampe Vᵣₐₘₚₑ. Le circuit d'horloge 45 peut recevoir en entrée le premier signal d'horloge CLK et fournir en sortie le signal triangulaire Vᵣₐₘₚₑ pour les comparateurs C1 et C2. Pour ce faire, la sortie du circuit d'horloge 45 peut être connectée à une des deux entrées de comparaison de chaque comparateur C1, C2.

Le signal triangulaire Vᵣₐₘₚₑ permet de définir la plage de variation du déphasage possible entre les deux signaux de sortie. Suivant le rapport cyclique du signal de rampe cette plage peut s'étaler jusqu'à 180°.

Le circuit selon un mode de réalisation de l'invention peut comprendre également deux bascules de type ^{«} D ^{»}. Ces bascules peuvent être actives sur front montant ou descendant.

La première bascule D1 reçoit, sur son entrée d'horloge, le signal de sortie Cmp1 du premier comparateur C1 et la deuxième bascule D2 le signal de sortie Cmp2 du deuxième comparateur C2. Le signal de sortie CLK_2 du circuit diviseur de fréquence 46 est envoyé sur l'entrée ^{«} D ^{»} de chacune des bascules D1 et D2.

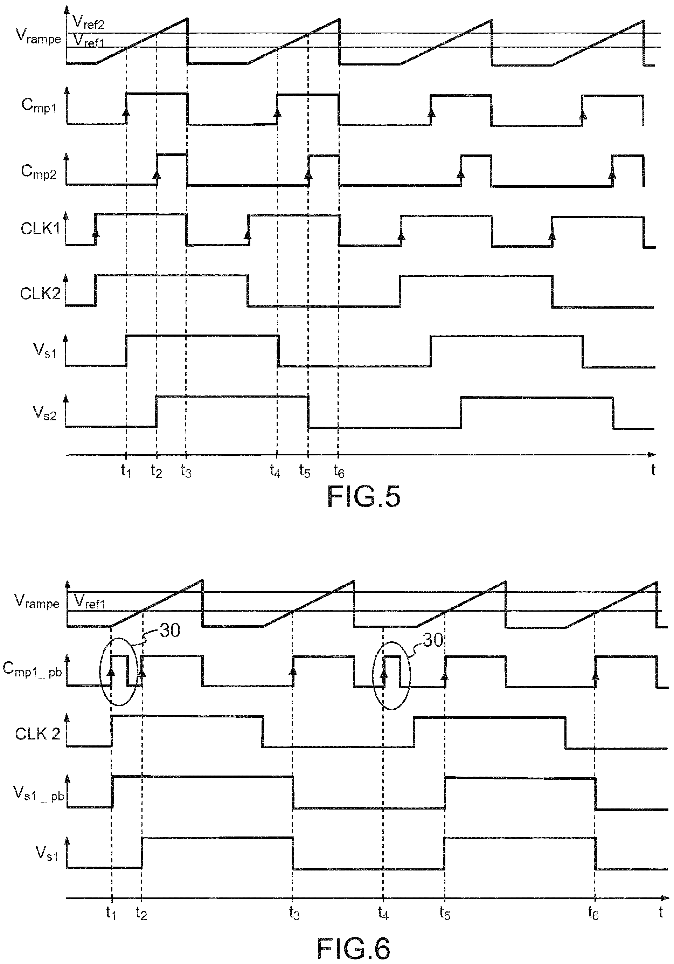

Le fonctionnement du circuit va à présent être expliqué à l'aide des exemples de chronogrammes de la figure 5.

Le premier chronogramme correspond au signal de rampe Vᵣₐₘₚₑ. Les deux chronogrammes suivants représentent respectivement les signaux en sortie des premier et deuxième comparateurs C1, C2. Les quatrième et cinquième chronogrammes illustrent respectivement le premier signal d'horloge CLK en entrée du circuit diviseur de fréquence 46 et le signal de sortie CLK_2 dudit diviseur. Le signal premier d'horloge CLK est synchrone avec le signal de rampe et le signal de sortie CLK_2 présente une fréquence divisée par deux par rapport au signal d'entrée CLK du circuit diviseur de fréquence 46. Les deux derniers chronogrammes représentent les signaux en sortie des deux bascules D1, D2.

Au temps t₁, la valeur du signal de rampe devient supérieure à la valeur de la première tension de seuil V_{S1}, le signal de sortie du premier comparateur C1 passe de l'état bas à l'état haut. La première bascule D1 détecte le front montant et recopie en sortie la valeur du deuxième signal d'horloge CLK_2 à savoir un état haut, le signal en sortie de la bascule D1 passe donc de l'état bas à l'état haut.

Au temps t₂, la valeur du signal de rampe devient supérieure à la valeur de la deuxième tension de seuil V_{S2}. Le signal de sortie du deuxième comparateur C2 passe donc de l'état bas à l'état haut. La deuxième bascule D2 se déclenche et son signal de sortie prend la même valeur que le deuxième signal d'horloge CLK_2 à savoir un état haut.

Au temps t₃, la valeur du signal de rampe revient à zéro, les signaux de sortie des deux comparateurs C1, C2 passent de l'état haut à l'état bas.

Au temps t₄, la valeur du signal de rampe devient de nouveau supérieure à la valeur de la première tension de seuil V_{S1}, le signal de sortie du premier comparateur C1 passe à l'état haut et déclenche la première bascule D1 qui recopie en sortie la valeur du deuxième signal d'horloge CLK_2. Son signal de sortie passe de l'état haut à l'état bas.

De même, au temps t₅, la valeur du signal de rampe devenant supérieure à la valeur de la deuxième tension de seuil V_{S2} déclenche un front montant en sortie du deuxième comparateur C2. Ce front montant fait déclencher la deuxième bascule D2 et son signal de sortie passe de l'état haut à l'état bas.

On obtient ainsi, en sortie du circuit 40, deux signaux d'horloge rectangulaires déphasés dans le temps. Le déphasage entre les deux signaux peut être réglé en modifiant la valeur des deux tensions de seuil V_{S1} et V_{S2}. Comme vu précédemment, la plage de variation du déphasage dépend du rapport cyclique du signal de rampe.

Bien entendu, ce circuit 40 peut se généraliser à un nombre de signaux rectangulaires supérieur à deux. Pour un nombre n de signaux rectangulaires déphasés dans le temps, avec n représentant un entier supérieur à un, le circuit comprendra n comparateurs et n bascules de type ^{«} D ^{»} et recevra en entrée n tensions de seuil.

La figure 6 illustre, par des exemples de chronogrammes, le cas où des parasites 30 apparaitraient sur le signal de sortie Cmp1_Pb du premier comparateur C1 du circuit 40 de la figure 4. Sur cette figure a été représenté respectivement, un signal de rampe, le signal en sortie du premier comparateur C1, un signal de sortie CLK_2 du circuit diviseur de fréquence 46, un signal de sortie de la deuxième bascule D2 et un signal de sortie de la deuxième bascule D2 dans le cas sans parasite.

On suppose qu'un signal parasite 30 apparaît au temps t₁ sur le signal de sortie du premier comparateur C1. Le front montant de ce parasite 30 fait déclencher la bascule D1 qui recopie la valeur du deuxième signal d'horloge CLK_2 à savoir un état haut. Le signal de sortie S_{1_Pb} de la bascule D1 change donc d'état au temps t₁ au lieu du temps t₂.

Au temps t₂ le signal de sortie du comparateur C1 présente de nouveau un front montant. En détectant ce front montant, la bascule D1 recopie le signal CLK_2 et reste à l'état haut. Contrairement au cas du circuit présenté à la figure 1, le signal de sortie S_{1_Pb} ne change pas d'état à chaque front montant présent sur le signal de sortie du comparateur. De même, on peut remarquer que le signal de sortie S_{1_Pb} n'est pas perturbé de façon définitive mais seulement de façon temporaire. Le front montant suivant le signal parasite 30 permet de rétablir le signal de sortie de bascule S₁ à son niveau normal, c'est-à-dire à l'état logique qu'il aurait eu s'il n'y avait pas eu de parasites 30 sur le signal en sortie du comparateur C1.

On peut également remarquer que suivant l'instant où survient le signal parasite 30, ce dernier peut ne pas perturber le signal en sortie de bascule. Par exemple, le signal parasite à l'instant t₄ n'a aucun effet sur le signal de sortie S₁.

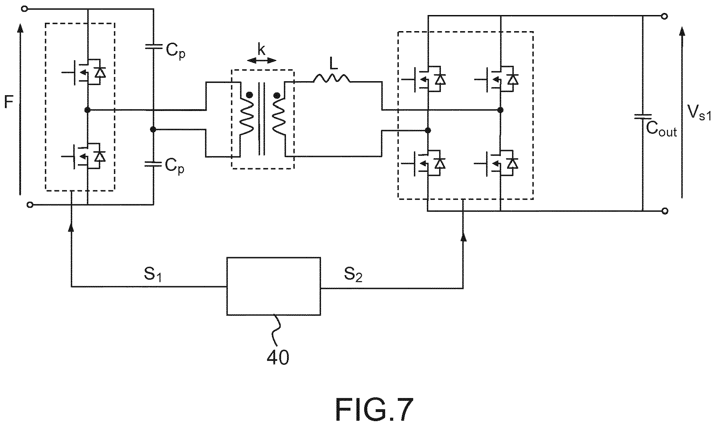

Suivant un exemple nullement limitatif, ce circuit peut trouver une application dans un convertisseur d'énergie à décalage de phase ou ^{«} phase shift ^{»} selon la terminologie anglo-saxonne. A titre illustratif, la figure 7 représente un exemple de réalisation d'un convertisseur d'énergie à décalage de phase dans lequel un déphasage entre les bras de ponts primaires et secondaires est créé à l'aide d'un circuit 40 de génération d'au moins deux signaux rectangulaires à déphasage réglable selon un mode de réalisation de l'invention . Dans ce circuit, les signaux de sortie S₁, S₂ du circuit 40 de génération de signaux rectangulaires à déphasage réglable sont configurés pour commander les différents commutateurs des ponts primaire et secondaire du convertisseur de puissance.

De façon avantageuse, le circuit de génération de signaux selon l'invention permet de s'affranchir des problèmes de synchronisation des bascules ainsi que des problèmes liés à la remise à zéro des bascules.

Ce circuit permet également de minimiser les conséquences d'une ou plusieurs impulsions parasites.

## Revendications

1. Circuit (40) de génération d'au moins deux signaux rectangulaires (S₁, S₂) à déphasage réglable **caractérisé en ce qu'**il comprend :
- un circuit diviseur de fréquence (46) recevant en entrée un premier signal d'horloge (CLK) et fournissant en sortie un deuxième signal d'horloge (CLK_2),
- au moins deux comparateurs (C1, C2), recevant respectivement sur une entrée de comparaison une première tension de seuil (Vs₁) et au moins une seconde tension de seuil (Vs₂) et sur une seconde entrée de comparaison un signal triangulaire de rampe synchronisé avec le signal d'horloge (CLK), le groupe d'au moins deux tensions de seuil (Vs₁, Vs₂) permettant de régler la valeur du déphasage entre les signaux du groupe d'au moins deux signaux rectangulaires à déphasage réglable,
- au moins deux bascules de type D (D1, D2) recevant respectivement sur leurs entrées d'horloge, le signal de sortie (Cmp1) du premier comparateur et le signal de sortie (Cmp2) du deuxième comparateur et sur leur entrée ^{«} D ^{»}, le signal de sortie (CLK_2) du circuit diviseur de fréquence (46),
le groupe d'au moins deux signaux rectangulaires (S₁, S₂) à déphasage réglable étant disponible sur les sorties ^{«} Q ^{»} du groupe d'au moins deux bascules de type D (D1, D2).

2. Circuit (40) suivant la revendication précédente selon lequel le circuit diviseur de fréquence (46) est un diviseur de fréquence par deux.

3. Circuit (40) suivant une des revendications précédentes selon lequel le circuit diviseur de fréquence (30) comprend une bascule de type ^{«} D ^{»} dont l'entrée D est connectée à la sortie complémentaire ^{«} Q* ^{»}.

4. Circuit (40) suivant une des revendications précédentes comprenant en outre un circuit d'horloge (45) configuré pour générer un signal triangulaire de rampe, ledit circuit d'horloge (45) recevant en entrée le signal d'horloge (CLK) et la sortie dudit circuit d'horloge étant connecté à une des deux entrées de comparaison de chaque comparateur (C1, C2).

5. Convertisseur de puissance à décalage de phase **caractérisé en ce qu'**il comprend un circuit (40) de génération de deux signaux rectangulaires à déphasage réglable selon une des revendications précédentes, lesdits signaux rectangulaires étant configurés pour commander des commutateurs des ponts primaire et secondaire dudit convertisseur de puissance.

## Patentansprüche

1. Schaltung (40) zum Erzeugen von wenigstens zwei Rechtecksignalen (S₁, S₂) mit regelbarer Phasenverschiebung, **dadurch gekennzeichnet, dass** sie Folgendes umfasst:
- eine Frequenzteilerschaltung (46), die am Eingang ein erstes Taktsignal (CLK) empfängt und am Ausgang ein zweites Taktsignal (CLK_2) ausgibt,
- wenigstens zwei Komparatoren (C1, C2), die jeweils an einem Vergleichseingang eine erste Schwellenspannung (Vs₁) und wenigstens eine zweite Schwellenspannung (Vs₂) empfangen und an einem zweiten Vergleichseingang ein mit dem Taktsignal (CLK) synchronisiertes dreieckiges Rampensignal empfangen, wobei die Gruppe von wenigstens zwei Schwellenspannungen (Vs₁, Vs₂) das Regeln des Phasenverschiebungswertes zwischen den Signalen der Gruppe von wenigstens zwei Rechtecksignalen mit regelbarer Phasenverschiebung zulässt,
- wenigstens zwei Flipflops des D-Typs (D1, D2), die jeweils an ihren Takteingängen das Ausgangssignal (Cmp1) des ersten Komparators und das Ausgangssignal (Cmp2) des zweiten Komparators empfangen und an ihrem "D"-Eingang das Ausgangssignal (CLK_2) der Frequenzteilerschaltung (46) empfangen,
wobei die Gruppe von wenigstens zwei Rechtecksignalen (S₁, S₂) mit regelbarer Phasenverschiebung an den "Q"-Ausgängen der Gruppe von wenigstens zwei Flipflops des D-Typs (D1, D2) verfügbar ist.

2. Schaltung (40) nach dem vorherigen Anspruch, bei der die Frequenzteilerschaltung (46) ein Frequenz-Zweiteiler ist.

3. Schaltung (40) nach einem der vorherigen Ansprüche, bei der die Frequenzteilerschaltung (30) einen Flipflop des "D"-Typs umfasst, dessen D-Eingang mit dem komplementären "Q*"-Ausgang verbunden ist.

4. Schaltung (40) nach einem der vorherigen Ansprüche, die ferner eine Taktschaltung (45) umfasst, konfiguriert zum Erzeugen eines dreieckigen Rampensignals, wobei die Taktschaltung (45) am Eingang das Taktsignal (CLK) empfängt und der Ausgang der Taktschaltung mit einem der beiden Vergleichseingänge jedes Komparators (C1, C2) verbunden ist.

5. Leistungswandler mit Phasenverschiebung, **dadurch gekennzeichnet, dass** er eine Schaltung (40) zum Erzeugen von zwei Rechtecksignalen mit regelbarer Phasenverschiebung nach einem der vorherigen Ansprüche umfasst, wobei die Rechtecksignale zum Steuern der Schalter von primären und sekundären Brücken des Leistungswandlers konfiguriert sind.

## Claims

1. A circuit (40) for generating at least two rectangular signals (S₁, S₂) with adjustable phase shift, **characterized in that** it comprises:
- a frequency divider circuit (46) that receives a first clock signal (CLK) as input and provides a second clock signal (CLK_2) as output;
- at least two comparators (C1, C2) that receive, respectively, a first threshold voltage (Vs₁) and at least a second threshold voltage (Vs₂) at one comparison input, and a triangular ramp signal, synchronized with the clock signal (CLK), at a second comparison input, the group of at least two threshold voltages (Vs₁, Vs₂) allowing the value of the phase shift between the signals of the group of at least two rectangular signals with adjustable phase shift to be adjusted;
- at least two D-type flip-flops (D1, D2) that receive, respectively, the output signal (Cmp1) from the first comparator and the output signal (Cmp2) from the second comparator at their clock inputs, and the output signal (CLK_2) from the frequency divider circuit (46) at their "D" input,
the group of at least two rectangular signals (S₁, S₂) with adjustable phase shift being available at the "Q" outputs of the group of at least two D-type flip-flops (D1, D2).

2. The circuit (40) as claimed in the preceding claim, according to which the frequency divider circuit (46) is a divide-by-two frequency divider.

3. The circuit (40) as claimed in any one of the preceding claims, according to which the frequency divider circuit (30) comprises a "D"-type flip-flop the D-input of which is connected to the complementary "Q*" output.

4. The circuit (40) as claimed in any one of the preceding claims, additionally comprising a clock circuit (45) configured to generate a triangular ramp signal, said clock circuit (45) receiving the clock signal (CLK) as input and the output of said clock circuit being connected to one of the two comparison inputs of each comparator (C1, C2).

5. A phase-shifted power converter, **characterized in that** it comprises a circuit (40) for generating two rectangular signals with adjustable phase shift as claimed in any one of the preceding claims, said rectangular signals being configured to control switches of the primary and secondary bridges of said power converter.
